# EUROPEAN PATENT APPLICATION

(11) **EP 4 123 699 A1**
(43) Date of publication of application: **25.01.2023**
(21) Application number: 21187090.2
(22) Date of filing: 22.07.2021
(51) Int. Cl.: H01L 23/48, H01L 21/60, H01L 21/56, H01L 23/495, H01L 23/367, H01L 23/433, H01L 23/467, H01L 23/473

(54) **A SEMICONDUCTOR DEVICE AND A METHOD OF MANUFACTURING OF A SEMICONDUCTOR DEVICE**

(71) Applicant: Nexperia B.V., 6534 AB Nijmegen (NL)
(72) Inventor: Yandoc, Ricardo, 6534 AB Nijmegen (NL); Brown, Adam, 6534 AB Nijmegen (NL); Tang, Qingyuan, 6534AB Nijmegen (NL)
(74) Representative: Pjanovic, Ilija

(57) **Abstract**

This disclosure relates to a semiconductor device comprising a lead frame (102), a die (104) attached to the lead frame (102) using a first solder, a source clip (106) and a gate clip (108) attached to the die (104) using a second solder, and a drain clip (110) attached to the lead frame (102). The semiconductor device is inverted, so that the source clip (106) and the gate clip (108) are positioned on the bottom side of the semiconductor device, and wherein the lead frame (102) is positioned on the top side of the semiconductor device (104) so that the lead frame (102) is a top exposed drain clip. The disclosure is also related to a method of manufacturing the semiconductor device.

## Description

### FIELD

The present invention relates to a semiconductor device. The invention also relates to a method of manufacturing of a semiconductor device.

### BACKGROUND

A known loss free package (LFPAK) semiconductor device is described in US patent US6777800B2. A semiconductor die is mounted to a lead frame with leads. Wires couple the semiconductor die to the leads. The wires, the semiconductor die and then the most of the lead frame are then encapsulated in a molding material. The molding material is then shaped. The formed semiconductor die package includes a molded body that has leads extending laterally away from the molded body. The semiconductor die package is mounted onto a circuit board.

As consumer electronics (e.g., cell phones, laptop computers, etc.) continue to decrease in size, there is an ever increasing demand for thinner electronic devices and thinner electronic components. In addition, the heat dissipation properties of a semiconductor die package should be improved. For example, power semiconductor devices such as vertical MOSFETs (metal oxide field effect transistors) can generate a significant amount of heat. For high output power applications (e.g., more than 60 Watts), special packaging is required to remove heat from the power transistor to prevent overheating. Overheating can also degrade the operational characteristics of a power transistor.

In one embodiment described in the above mentioned patent a semiconductor die package comprises: (a) a semiconductor die comprising a first surface, a second surface, and a vertical power MOSFET having a gate region and a source region at the first surface, and a drain region at the second surface; (b) a drain clip having a major surface and being electrically coupled to the drain region; (c) a gate lead electrically coupled to the gate region; (d) a source lead electrically coupled to the source region; and (e) a non-conductive molding material encapsulating the semiconductor die, wherein the major surface of the drain clip is exposed through the non-conductive molding material.

In another embodiment of the above mentioned patent a semiconductor die package comprises: (a) a semiconductor die comprising a first surface, a second surface, and a vertical power MOSFET having a gate region and a source region at the first surface, and a drain region at the second surface; (b) a drain clip having a major surface and being electrically coupled to the drain region; (c) a drain lead electrically coupled to an end of the drain clip; (d) a gate lead electrically coupled to the gate region; (e) a source lead structure including at least one source lead and a protruding region having a major surface, and a die attach surface opposite the major surface of the source lead structure, the die attach surface being electrically coupled to the source region; and (f) a non-conductive molding material encapsulating the semiconductor die, wherein the major surface of the drain clip is exposed through the non-conductive molding material.

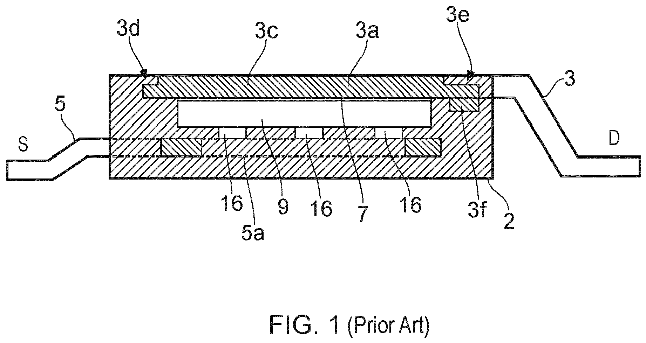

Another known semiconductor device is shown in Figure 1. The device comprises an inverted MOSFET package, with an exposed drain tab on the top of the device with gull wing leads.

Also known in the art are semiconductor packages combining several semiconductor components into a single package so to simplify circuit design, reduce costs, and provide greater efficiency and improved performance by keeping related and dependent circuit components in close proximity. These integrated multi-chip device packages facilitate application integration and greater electrical and thermal performance compared to using discrete components. This trend towards greater circuit integration has resulted in the development and use of the power quad flat no-lead (PQFN) package, which can comprise a multi chip module (MCM) in larger form factors such as 12 mm by 12 mm. By exposing large surface area die pads on the bottom surface of the PQFN package, performance is optimized for high power density circuit applications requiring efficient thermal dissipation.

One of the advantages of the PQFN package is the low cost of fabrication, as a simple low cost leadframe is utilized for the base material rather than expensive multi-layered substrates. However, as a result of this single layer configuration, electrical wiring and routing becomes a particular challenge, particularly for larger and more complex multi chip modules supported by the 12 mm by 12 mm form factor. Package designs directly interconnecting power devices such as power MOSFETs and IGBTs using multilayer substrates are not possible using simple single layer lead frames. Since much of the top surface electrical interconnects must be by wirebonds, wire layouts must be carefully designed to prevent wire shorting. While increasing package thickness may reduce the risks of wire shorting, this is often undesirable for maintaining package reliability as the risk of package cracking may increase.

### SUMMARY

Various example embodiments are directed to the disadvantage as described above and/or others which may become apparent from the following disclosure.

According to an embodiment of this invention a semiconductor device comprises a lead frame, a die attached to the lead frame using a first solder, a source clip and a gate clip attached to the die using a second solder, and a drain clip attached to the lead frame. The semiconductor device is inverted, so that the source clip and the gate clip are positioned on the bottom side of the semiconductor device, and wherein the lead frame is positioned on the top side of the semiconductor device so that the lead frame is a top exposed drain clip.

The drain clip can be made of copper. The drain clip can be a bended pillar. In a preferred embodiment of the present invention the bended pillar has a bending angle of about 90 degrees.

In an embodiment of the present invention the bended pillar is arranged so to prevent any mechanical tilting within the semiconductor device.

In a further embodiment of the present invention the bended pillar is arranged so to maintain the same level for all parts of the semiconductor device.

The semiconductor device as described in the above embodiments can be a PQFN semiconductor device, or a HEMT semiconductor device, or a MOSFET semiconductor device.

In an embodiment of the present invention, the semiconductor device as described in the above embodiments further comprises two cooling systems, a first cooling system positioned on the top side on the semiconductor device and a second cooling system positioned on the bottom side of the semiconductor device.

The invention also relates to a method of manufacturing a semiconductor device, wherein the method comprises the steps:
- creating a lead frame matrix comprising multiple lead frames,
- printing a first solder on the top of the lead frame matrix,
- attaching dies via the solder to the respective lead frames,
- creating source, gate and drain clips,
   o wherein the drain clip is bended and attached the respective lead frame, and
   o wherein the source and drain clips are attached to the respective dies,
- reflow,
- cleaning,
- mold array packing,
- grinding or polishing so to expose the source, gate and drain terminals,
- Sn plating,
- singulation,
- testing,
- inverting the semiconductor device, and
- mounting.

The semiconductor device as described in the above embodiments and having a bended Cu pillar provides an additional advantage since it also protects the clip matrix, it acts as a feet to avoid any mechanical tilting, and it provides the maintaining of the same level for all parts of the semiconductor device.

Inverting the semiconductor device according to the embodiments of the present invention provides a significant advantage for the semiconductor device since this will create a source package/semiconductor device, which significantly improves the resistance, inductance, current handling capability and better thermal performance of the package/semiconductor device.

The semiconductor device according to the embodiments of the present invention, the semiconductor device having a source down cool package, has multiple advantages. The semiconductor device is more cost effective.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 shows a known semiconductor device;
Figure 2 illustrates a semiconductor device according to an embodiment of the present invention;
Figures 3, 4 and 5 illustrate a method of manufacturing of a semiconductor device according to an embodiment of the present invention;
Figure 6 illustrates a semiconductor device according to an embodiment of the present invention;
Figure 7 illustrates a semiconductor device according to an embodiment of the present invention.

### DETAILED DESCRIPTION

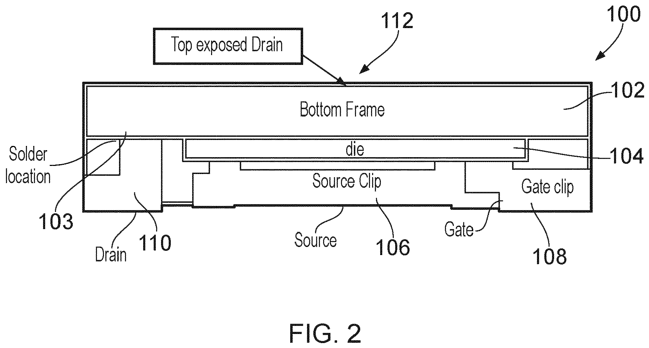

An embodiment of the present invention is shown in Figure 2, it relates to a semiconductor device 100 comprising a bottom frame 102, a die 104 connected by a solder 103 to the bottom frame 102, a source clip 106 connected to the die 104, a gate clip 108 connected to the die 104 and a drain clip 110 connected to the bottom frame 102. This semiconductor device is inverted, as shown in Figure 2, so that the source clip 106 and the gate clip 108 are positioned on the bottom of such semiconductor device 100 and wherein the bottom frame 102 is positioned on the top of such semiconductor device 100, which the bottom frame 102 is a top exposed drain clip 112.

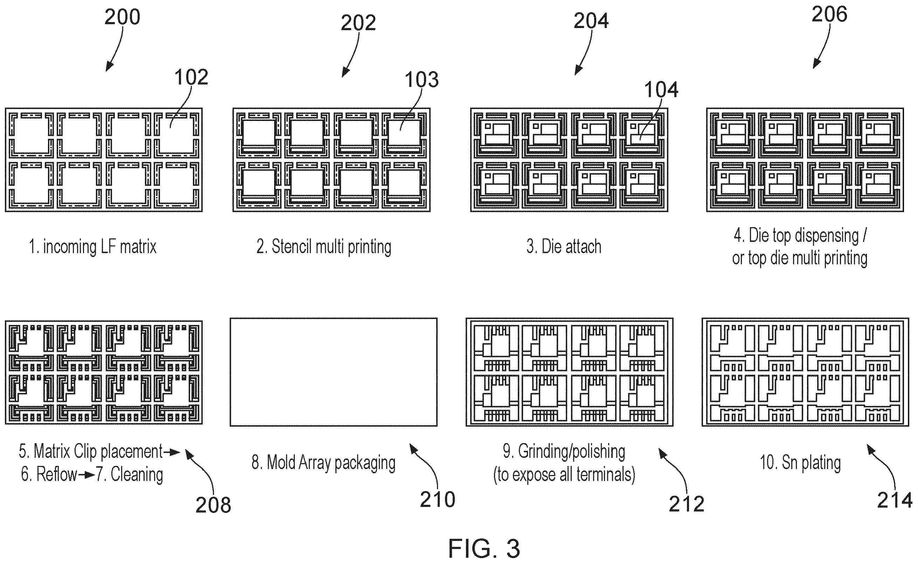

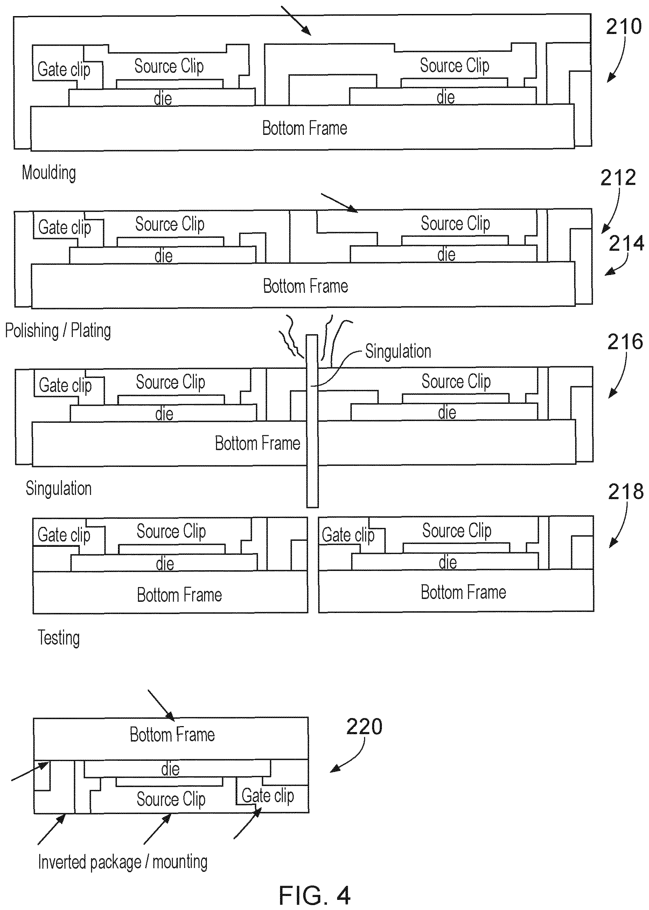

The invention also relates to a method of producing a semiconductor device. The method is shown in Figures 3 and 4.

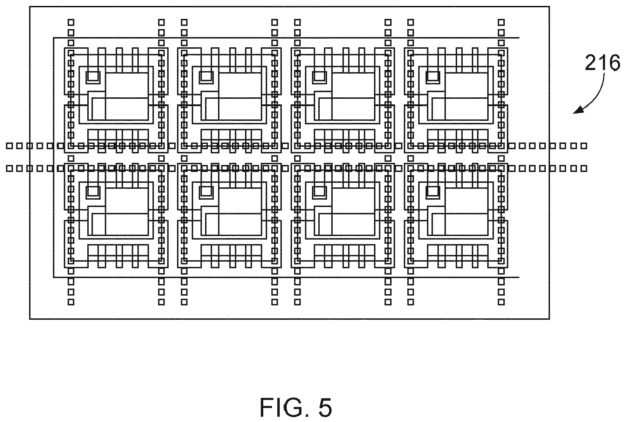

The method comprises the steps:
- creating lead frame matrix comprising multiple bottom frames 102 (reference number 200 in Figure 3),
- solder 103 multi printing on the top of the lead frame matrix (reference number 202 in Figure 3),
- attaching dies 104 via the solder 103 to the respective bottom frames 102 (reference number 204 in Figure 3),
- the die top dispensing, or the die top multi printing (reference number 206 in Figure 3),
- creating source, gate and drain clips, reflow, cleaning (reference number 208 in Figure 3),
- mold array packing (reference number 210 in Figures 3 and 4),
- grinding or polishing so to expose all terminals, i.e. source, gate and drain terminals (reference number 212 in Figures 3 and 4),
- Sn plating (reference number 214 in Figures 3 and 4),
- singulation (reference number 216 in Figures 4 and 5),
- testing (reference number 218 in Figure 4),
- inverting the semiconductor device and mounting (reference number 220 in Figure 4).

A semiconductor device created by this method is shown in Figure 4, reference number 220, and also in Figure 2.

A semiconductor device produced in this way is especially advantageous for power quad flat no-lead (PQFN) devices.

The novel features of the semiconductor device according to the previously described embodiments are listed below.

The semiconductor device comprises a relatively small bended Cu pillar, which forms a drain terminal/clip. In the manufacturing method described above the drain clip is initially connected on the source and/or gate clips, wherein all three clips are in the same plane surface, and wherein the drain clip is in the later method steps separated from source and/or gate clips by singulation. The singulation can be implemented as punch, sawing, laser singulation, or similar. In a preferred embodiment, the bending angle of the bended Cu pillar is about 90 degrees.

In a preferred embodiment of the present invention, the bending height of a drain clip is arranged to match the stacking height of the die, the solder and the clip.

Furthermore, such a bended Cu pillar provides an additional advantage since it also protects the clip matrix, it acts as a feet to avoid any mechanical tilting, and it provides the maintaining of the same level for all parts of the semiconductor device.

In a preferred embodiment of the present invention, the tip of this bended drain clip/terminal is attached on a matrix plane leadframe surface through standard known DACA process using a conductive adhesive such as a solder or similar, making the exposed back surface of the leadframe as a main drain terminal of the semiconductor device.

Said source terminal, gate terminal and the bended small drain terminal, that are on the same plane surface, are overmoulded (reference number 210 in Figures 3 and 4) and will be exposed through polishing/grinding process (reference numbers 212 and 214 in Figure 4), making a package with dual exposed drain terminal on the top and the bottom of the semiconductor.

Inverting the semiconductor device 100 (reference number 220 in Figure 4) provides a significant advantage for the semiconductor device since this will create a source package/semiconductor device, which significantly improves the resistance, inductance, current handling capability and better thermal performance of the package/semiconductor device.

Thus, the semiconductor device according to the previously described embodiments of the present invention will have an improved performance, since it will have relatively low parasitic inductance, relatively lower package resistance and relatively high current.

The semiconductor device according to the embodiments of the present invention combines two advantageous features, it has a source down package, and it has a top cooled drain clip/terminal which will increase advantage on thermal performance of such a semiconductor device, either by adding a heatsink on top of it, or using a water cooling system or an air cooling system.

The semiconductor device according to the embodiments of the present invention, the semiconductor device having a source down cool package, has multiple advantages. The semiconductor device is more cost effective compared to usage of ceramic substrates and a bare die, as known in the art.

In demanding applications, such as EPS, the semiconductor device according to the embodiments of the invention allows the use of FR4 PCB's instead of bare die modules.

Such a semiconductor device is an advantageous alternative to known bare die modules in BRM systems (10-20kW) which require a water cooling.

The semiconductor device according to the embodiments of the present invention also provides an improved power density, especially in dual redundant systems.

In case that the semiconductor devices is a HEMT device or a MOSFET device, the cooling of such a HEMT/MOSFET device from the top helps to reduce the temperature of the PCB. Having a PCB with a lower temperature allows that the other components can be placed relatively closer to the HEMT/MOSFET device.

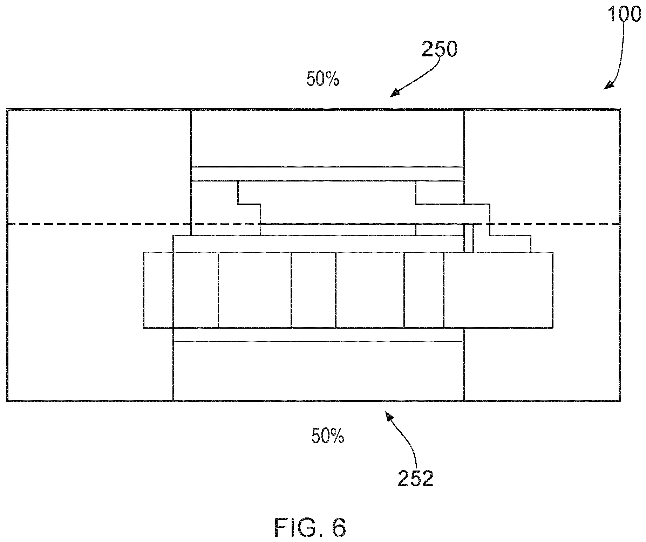

An embodiment of the present invention is shown in Figure 6. The semiconductor device 100 according to the embodiments of the present invention can be cooled from its top side 250 and also from its bottom side 252. Such a dual side cooling significantly improves the overall dissipation of the semiconductor device. Also the performance of the semiconductor device is maximized, i.e. Idmax is increased.

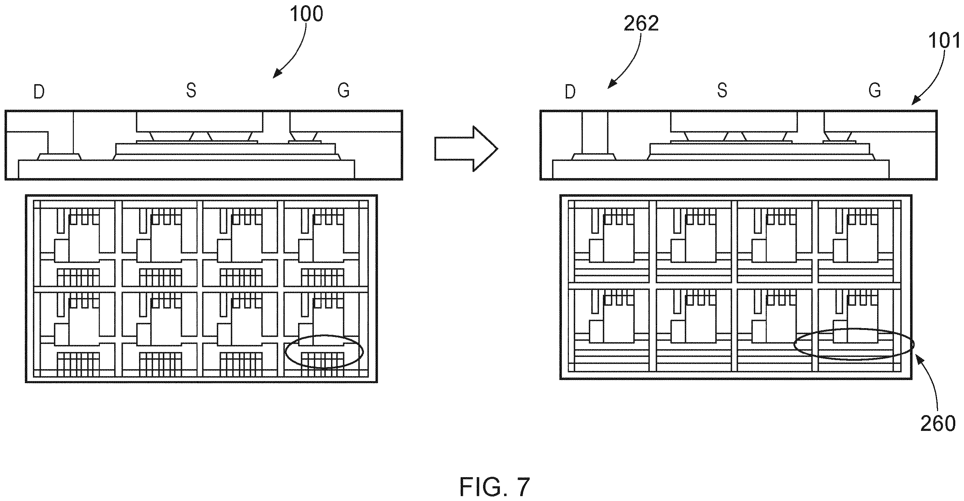

An embodiment of the present invention is shown in Figure 7. A semiconductor device 101 comprises a drain pillar/terminal/clip 260, 262 from the side of the clip, instead of connecting on the source and gate clips as shown in the previous described embodiment. This previous embodiment 100 is also shown in Figure 7 so to clearly specify the difference between these two embodiments of the present invention.

The embodiments of the present invention are applicable for all semiconductor packages/devices using clips as interconnects.

A semiconductor device according to an embodiment of the present invention is especially advantageous for PQFN semiconductor devices used at the automotive markets.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising:
- a lead frame,
- a die attached to the lead frame using a first solder,
- a source clip and a gate clip attached to the die using a second solder, and
- a drain clip attached to the lead frame,
wherein the semiconductor device is inverted, so that the source clip and the gate clip are positioned on the bottom side of the semiconductor device, and wherein the lead frame is positioned on the top side of the semiconductor device so that the lead frame is a top exposed drain clip.

2. A semiconductor device as claimed in claim 1, wherein the drain clip is made of copper.

3. A semiconductor device as claimed in any of the previous claims, wherein the drain clip is a bended pillar.

4. A semiconductor device as claimed in claim 3, wherein the bended pillar has a bending angle of about 90 degrees.

5. A semiconductor device as claimed in claims 3 or 4, wherein the bended pillar is arranged so to prevent any mechanical tilting within the semiconductor device.

6. A semiconductor device as claimed in claims 3, 4 or 5, wherein the bended pillar is arranged so to maintain the same level for all parts of the semiconductor device.

7. A semiconductor device as claimed in any of the previous claims, wherein the semiconductor device is a PQFN semiconductor device, or a HEMT semiconductor device, or a MOSFET semiconductor device.

8. A semiconductor device as claimed in any of the previous claims, wherein the semiconductor device further comprises two cooling systems, a first cooling system positioned on the top side on the semiconductor device and a second cooling system positioned on the bottom side of the semiconductor device.

9. A method of producing a semiconductor device, the method comprising the steps:
- creating a lead frame matrix comprising multiple lead frames,
- printing a first solder on the top of the lead frame matrix,
- attaching dies via the solder to the respective lead frames,
- creating source, gate and drain clips,
o wherein the drain clip is bended and attached the respective lead frame, and
o wherein the source and drain clips are attached to the respective dies,
- reflow,
- cleaning,
- mold array packing,
- grinding or polishing so to expose the source, gate and drain terminals,
- Sn plating,
- singulation,
- testing,
- inverting the semiconductor device, and
- mounting.
